Europäisches Patentamt

European Patent Office

Office européen des brevets

(11) Publication number: **0 101 739**
**B1**

# EUROPEAN PATENT SPECIFICATION

(45) Date of publication of patent specification: 23.05.90

(21) Application number: 83900660.8

(22) Date of filing: 18.02.83

(86) International application number:
PCT/JP83/00049

(87) International publication number:
WO 83/03032 01.09.83 Gazette 83/20

(51) Int. Cl.⁵: **H 01 L 29/72,** H 01 L 29/167,
H 01 L 29/08

(54) Heterojunction transistor and method of fabricating the same.

(30) Priority: 19.02.82 JP 24484/82
11.06.82 JP 99317/82

(43) Date of publication of application:
07.03.84 Bulletin 84/10

(45) Publication of the grant of the patent:
23.05.90 Bulletin 90/21

(84) Designated Contracting States:
DE FR NL

(56) References cited:
FR-A-2 309 981
GB-A-2 029 096
JP-A- 567 472
JP-A-5 246 779

(73) Proprietor: Hitachi, Ltd.
5-1, Marunouchi 1-chome
Chiyoda-ku Tokyo 100 (JP)

(72) Inventor: TANAKA, Tomoyuki
5-5, Ohmika-cho 6-chome Hitachi-shi
Ibaraki 319-12 (JP)
Inventor: YAMADA, Koichiro
12-10, Ohmika-cho 6-chome Hitachi-shi
Ibaraki 319-12 (JP)
Inventor: YASUDA, Yasumichi
10-3, Ohnuma-cho 1-chome Hitachi-shi
Ibaraki 316 (JP)

(74) Representative: Patentanwälte Beetz sen. -
Beetz jun. Timpe - Siegfried - Schmitt-Fumian
Steinsdorfstrasse 10
D-8000 München 22 (DE)

Courier Press, Leamington Spa, England.

## Description

Technical field:

This invention relates generally to a semiconductor device and more particularly, to a hetero junction transistor whose emitter region is constituted by a material having a forbidden band width greater than that of a material forming the base region.

Background art

A transistor whose emitter region is constituted by a material having a forbidden band width greater than that of a material forming the base region so that the emitter junction forms a hetero junction is known as a "wide gap emitter hetero junction transistor". The transistor having such a structure has high emitter injection efficiency and a great current amplification ratio $h_{FE}$.

As the combinations of materials forming an effectively operative hetero junction, a combination of $Ga \cdot Al \cdot As$ with $Ga \cdot As$, a combination of $Ga \cdot As$ with Ge and a combination of single crystal silicon with polycrystalline or amorphous silicon doped with oxygen are known.

FR—A—2,309,981 (corresponding to Japanese Patent Publication No. 37702/1981 and to US—A—4,062,034) discloses a semiconductor device having a hetero junction consisting of the combination of single crystal silicon with polycrystalline or amorphous silicon doped with oxygen. In this prior art device, a region having one conductivity type is selectively formed on one main surface of a single crystal silicon substrate having the other conductivity type to form a base region and a polycrystalline or amorphous silicon layer, which is doped with an impurity having a conductivity type opposite to that of the base region and with oxygen, is deposited on this main surface. The unnecessary portion(s) of this polycrystalline or amorphous silicon layer doped with the impurity and oxygen are then removed by photoetching techniques and the film is thereafter shaped in a predetermined shape to obtain an emitter having a hetero junction. A protective layer for passivation is formed after this emitter region is formed, and apertures are opened by photoetching techniques at those portions where electrodes are to be disposed. After the necessary electrodes are deposited in the ohmic contact arrangement, the semiconductor device is completed.

In practically producing the semiconductor device having the structure described above and in accordance with the fabrication method described above, however, a problem is encountered during the photoetching step in which the polycrystalline or amorphous silicon film doped with oxygen and the impurity such as P, for example, is shaped into a predetermined emitter shape. When a 1 µm-thick film is etched using an etching solution, which consists of a 1:5:20 mixture (by volume) of hydrofluoric acid, nitric acid and acetic acid and is known heretofore, and a photoresist KMER, which is commercially available from KODAK, as an etching mask, problems occur during etching that the mask peels and the film is completely lost, or the planar dimension of the emitter is reduced by 40 µm or more due to side etching. If the film is lost, the resulting device can not naturally operate as a transistor. If the emitter size is reduced by as much as 40 µm by side etching, the pellet area necessary for obtaining a desired current capacity must be increased in advance. Hence, a device having a pattern size of below 100 µm such as a high frequency transistor or a transistor inside IC can not be fabricated in practice. The semiconductor device fabricated in accordance with the fabrication method described above mostly lacks sufficient reliability and withstand voltage. Photoetching must be carried out for each wafer and is by far more time-consuming than other fabrication steps such as oxidation and diffusion (some dozens or hundreds of wafers can be processed at once). Moreover, since photoetching accounts for the major proportion of the production cost of the device, it has been earnestly desired to somehow improve the photoetching step.

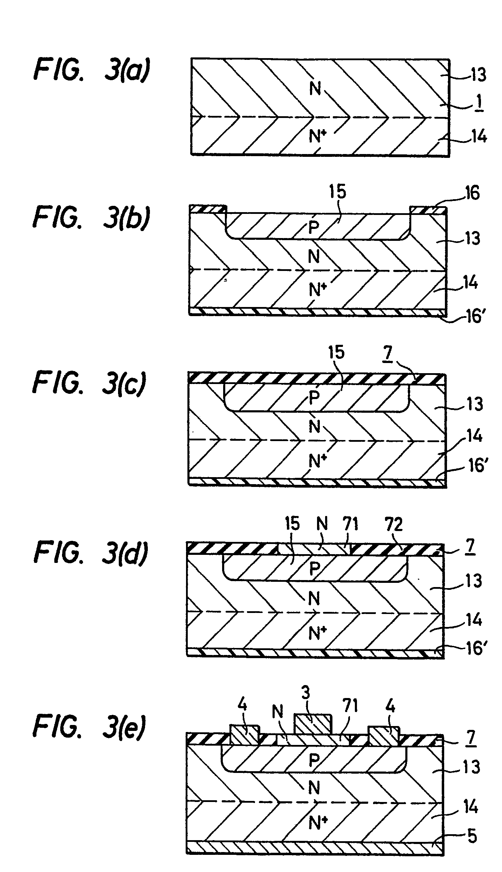

FR—A—2 309 981 (corresponding to Japanese Patent Publication no. 37702/1981 and to US—A—4 062 034) does not disclose to use different portions of the same O-doped polycrystalline or amorphous silicon layer as an emitter region formed by selective additional doping and as a passivation film lacking said additional doping. In the prior art, either the emitter only is formed from predoped polysilicon material and passivation relies on a conventional silicon oxide layer (cf., e.g., Figure 3) or both the emitter and the passivation layer are formed of O-doped polysilicon which is however deposited in two different subsequent steps in accordance with the respective impurity concentrations (cf., e.g., Figure 7 further showing a polysilicon base layer). In both cases a photoetching step determining the emitter shape and removing the superfluous predoped material outside the emitter is necessary.

Disclosure of invention

It is an object of the present invention to provide a heterojunction transistor and method of fabricating the same with a reduced photoetching step.

It is another object of the present invention to provide a heterojunction transistor having a heretojunction with high withstand voltage as well as high reliability, and a method of fabricating the same.

In the heterojunction transistor fabricated in accordance with the present invention, a polycrystalline or amorphous silicon layer doped with oxygen is disposed on a single silicon semiconductor substrate, and an impurity is selectively doped into only a part of this silicon layer to form a semiconductor layer having a desired conductivity type. The portion of the silicon layer, at which only oxygen is doped, functions as a passivation film. In other words, the present invention discloses that an emitter and a passivation layer are deposited in the same step using the same O-doped polysilicon layer as apparent from the following explanation.

The heterojunction transistor is fabricated in accordance with the present invention by the steps of:

forming a base region having one conductivity type in a part of a single crystal silicon substrate having the opposite conductivity type to generate a p-n junction the end portions of which are exposed on one main surface of said silicon substrate;

covering said one main surface of said single crystal silicon substrate with an O-doped polycrystalline or amorphous silicon layer;

doping an impurity of said opposite conductivity type into a portion of said O-doped polycrystalline or amorphous silicon layer which is located on said base region to generate an emitter region having said opposite conductivity type and forming a heterojunction with said base region; and

leaving a portion of said O-doped polycrystalline or amorphous silicon layer not doped with said impurity of opposite conductivity type as a passivation film.

In this case, the photoetching step that has been necessary conventionally for forming the emitter is no longer necessary. If an impurity having the same conductivity type as that of the base region is doped to a portion of the O-doped polycrystalline or amorphous silicon layer where a base electrode contact portion is to be formed, it becomes possible to eliminate the photoetching step for opening the window for the base electrode forming portion, in addition to the photoetching step for forming the emitter.

Brief description of drawings

Figure 1 is an enlarged sectional view showing the heterojunction transistor fabricated in accordance with an embodiment of the present invention;

Figure 2 is an enlarged sectional view showing the heterojunction transistor in accordance with another embodiment of the present invention;

Figure 3 is a sectional view showing step-wise the fabrication steps of the heterojunction transistor in accordance with the present invention; and

Figure 4 is a sectional view of the heterojunction transistor and useful for explaining the fabrication steps in accordance with another embodiment of the present invention.

Best mode for carrying out the invention

Preferred embodiments of the present invention will be described in detail with reference to the accompanying drawings.

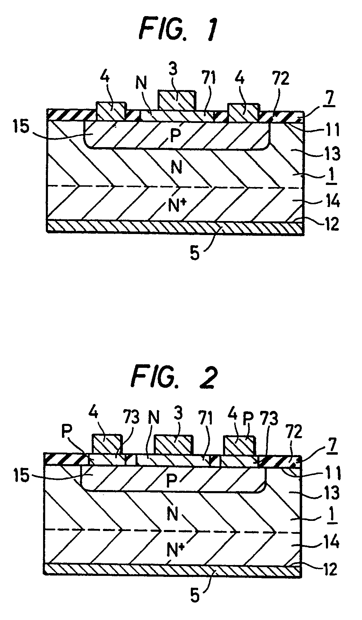

Figure 1 is an enlarged sectional view showing a hetero junction transistor fabricated in accordance with an embodiment of the present invention.

In Figure 1, an n-type collector layer 13 having relatively high resistivity, an n-type collector layer 14 having relatively low resistivity and a p-type base layer 15 having relatively low resistivity are shown disposed between a pair of main surfaces 11, 12 of a single crystal silicon substrate 1. Formed on one 11 of the main surface of the substrate 1 is a semiconductor layer 7 which consists of an O-doped polycrystalline or amorphous silicon and having a forbidden band width greater than that of the substrate 1 and high resistivity. This layer 7 consists of a first portion 71 which is positioned close to the surface of a selected portion of the base layer 15 and is doped with an impurity such as P, and a portion 72 which consists solely of the O-doped polycrystalline or amorphous silicon. These portions 71 and 72 function as an n-type emitter and a passivation film, respectively. An emitter electrode 3 which comes into ohmic contact with the surface of the portion 71, a base electrode 4 which penetrates through a part of the portion 72 and comes into ohmic contact with the surface of the base layer 15 and a collector electrode 5 which comes into ohmic contact with the surface of the collector layer 14 are disposed, respectively.

Figure 2 is an enlarged sectional view of the heterojunction transistor in accordance with another embodiment of the present invention.

The semiconductor device shown in Figure 2 is the heterojunction transistor in the same way as in Figure 1. An oxygen-containing polycrystalline or amorphous silicon layer 7 is deposited on a single crystal silicon substrate 1 consisting of an n-type high resistivity layer 13 and an n-type low resistivity layer 14 that function as the collectors, and a p-type relatively low resistivity layer 15 functioning as the base. P and B are doped into portions 71 and 73, respectively. The portion 71 functions as the emitter and the portion 73, as the base electrode contact portion. The other portion covers the end portion of the p-n junction between the base and collector and the portion nearby, and functions as a passivation film. Emitter and base electrodes 3 and 4 are disposed on this silicon layer.

The semiconductor device in accordance with the present invention is fabricated in the following manner.

Figure 3 is a sectional view useful for explaining the fabrication steps of the heterojunction transistor shown in Figure 1.

First, P is diffused into an n-type single crystal silicon wafer having high resistivity to form an n$^+$ layer 14 and to obtain an n-on-n$^+$ wafer (see Figure 3(a)). This wafer is thermally oxidized to form oxide films (SiO$_2$ film) 16, 16'. On the other hand, an aperture is bored by photoetching at a portion of the SiO$_2$ film on one of the main surfaces where a base region is to be formed, and B is then diffused to obtain a p base layer 15. Thereafter, the SiO$_2$ film 16 on the wafer surface is removed, and the wafer is heated to 660°C inside a reaction furnace and is held for 50 minutes in the atmosphere of a mixed gas consisting of 25 l/min of N$_2$, 30 cm$^3$/min of SiH$_4$ and 60 cm$^3$/min of N$_2$O. Thus, an about 1 μm-thick polycrystalline or amorphous silicon film 7 having resistivity of

about $10^{10}$ Ohm · cm can be formed (see Figure 3(c)). This wafer is thermally oxidized in the oxygen stream to form an $SiO_2$ film, and only a portion where the emitter is formed is photo-etched to bore an aperture. P is introduced from this aperture by ion implantation. An accelerating voltage is 80 kV and an implantation quantity is about $1 \times 10^{15}$ cm$^{-2}$.

Incidentally, the oxygen doping quantity of the semiconductor layer 7 has relation with the current amplification ratio $h_{FE}$ of the transistor at the portion 71 and with the passivation performance at the portion 72. As a result of experiments, the inventors of this invention have found that the quantity may be within 0 to 30 atomic%. In the aspect of the passivation performance, the resistivity of the film is found increasing with an increasing O-doping quantity such as about $1 \times 10^7$ Ohm · cm at 0 atomic% and about $1 \times 10^{11}$ Ohm · cm at 30 atomic%. This means that the upper limit value of the thickness of the layer 72, which is necessary to keep a leakage current below a predetermined value, can be increased and hence, the freedom for design can be improved. When the doping quantity approaches 67 atomic% ($SiO_2$), however, the film becomes a dielectric and the disadvantages develop in that the field mitigation effect disappears in the substrate 1 and the field in the substrate 1 is easily affected by external influences such as the humidity of the atmosphere in which the device is placed. The reason why the portion 71 functions satisfactorily as the emitter even when the O-doping quantity is zero is found, as a result of analysis by infrared absorption and electron ray diffraction, that the band gap becomes greater than the single crystal Si because the silicon film contains the amorphous phase.

On the other hand, the greater the P-doping quantity at the portion 71 of the semiconductor layer 7, the better. However, its lower limit value is determined by the condition in which the layer 71 serves as the emitter of electrons and in which the voltage drop in the layer when a current flows through the transistor is sufficiently small. Hence, the doping quantity is preferably at least $4 \times 10^{19}$ atoms/cm$^3$.

Next, the wafer is heat-treated at a temperature of from 900 to 1,100°C and P is extended, spread and activated throughout the direction of thickness of the film 7. If the time of this activating heat treatment is too long in this activating treatment, P will come into the p-type layer 15 of the single crystal silicon substrate 1 and forms an n-type inversion layer inside the single crystal silicon substrate. When the thickness of the inversion layer exceeds the length of diffusion of electrons, the semiconductor device is no longer a heterojunction semiconductor device. The upper limit of the heat-treating time is determined in view of this point. The lower limit is the longer of the time at which the activation ratio of P reaches a saturation value and the time at which the P concentration on the interface of the heterojunction becomes sufficiently high. A desired result can be obtained by carrying out the heat-treatment for several minutes to some dozens of minutes under the film-forming conditions described above.

Next, an aperture is bored by photoetching at a portion of the film 7 where the base electrode is to be bonded and Cr—Au is vacuum-deposited as an emitter-base electrode.

In the transistor of this embodiment, the p base layer 15 is 18 μm thick, the acceptor dose quantity is about $2 \times 10^{14}$ cm$^{-2}$, the n-type collector layer 13 has resistivity of 90 Ohm · cm, a thickness of 90 μm and $h_{FE}$ is 100 to 200. When the forming conditions of the base and the collector are the same, this becomes about 10 times that of the conventional homojunction transistor. The breakdown voltage between the collector and the emitter is about 400 V and the leakage current is up to $10^{-8}$ A.

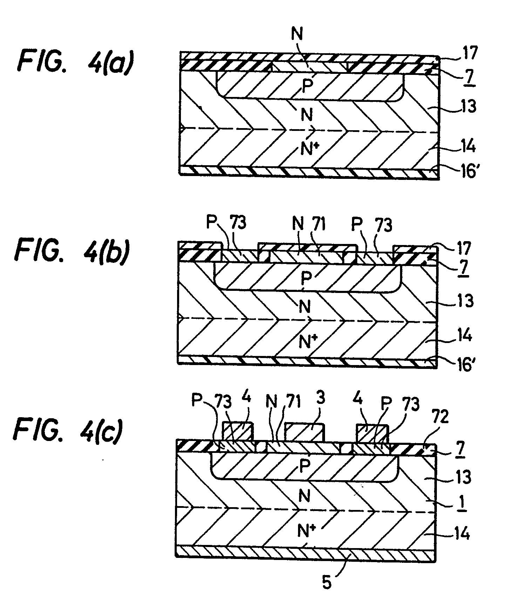

Figure 4 is a sectional view useful for explaining the fabrication steps of the heterojunction transistor shown in Figure 2, and shows the case where the base electrode contact portion is disposed on the semiconductor layer 7.

The procedures up to the doping step of P to a desired portion of the semiconductor layer 7 shown in Figure 3(c) so as to form the emitter portion are exactly the same as those of the fabrication process described above. Thereafter, the wafer surface is again oxidized (Figure 4(a)) and an aperture is bored at a predetermined portion of the oxide film 16 which is to serve as a base electrode contact portion. B is implanted in a dose of about $10^{15}$ cm$^{-2}$, forming a B-doped polycrystalline or amorphous silicon layer 73 having low resistivity (Figure 4(b)). After the activating treatment of P and B is effected at 900 to 1,100°C, an electrode material (Cr—Au) is vacuum-deposited to form emitter, base and collector electrodes 3, 4, and 5 having predetermined shapes, respectively. Hydrogen treatment is then carried out at 450°C to complete the transistor of the embodiment shown in Figure 2. The transistor thus completed has $h_{FE}$ of about 120 and this is about 5 times that of the conventional transistor (homojunction transistor) in which the base and collector layers are the same.

The polycrystalline or amorphous silicon film 7 in the semiconductor device of the present invention may consist of two layers: of an O-doped layer and a layer not doped with O. In this case, electrode metals such as Al, Al—Si and the like that have been used generally for transistors can be used as the electrode material. In this case, the emitter film has a two-layered structure, too, but in accordance with the conventional fabrication process, a problem different from the problems described already occurs in the photoetching step of the emitter film. In other words, the layer not doped with O has a by far higher etching speed than the O-doped layer when an ordinary etching solution is used and consequently, only this layer is remarkably side-etched. Accordingly, delicate etching of the emitter becomes difficult. In accordance with the structure of the present invention, however, etching of the emitter is not necessary and such a problem does not occur.

In forming the emitter region by doping P, P may be doped by a heretofore known diffusion technique of P instead of ion implantation. In such a case, P can be doped without using an ion implantation equipment. Activation in the activating treatment can also be made by radiating laser light having an energy of 1 to 5 J/cm² for 10 to 100 ns. In such a case, there can be obtained the advantages that the activating treatment can be carried out within an extremely short period of time and when the energy of the laser light is optimized, P in the film 7 is hardly diffused into the single crystal layer, an excellent heretojunction can be formed and extremely high P activation ratio can be obtained.

In accordance with the fabrication process of the present invention, a heterojunction having high reliability, high withstand voltage passivation and high injection efficiency can be obtained with a reduced number of photoetching steps and hence, the present invention greatly contributes to practical semiconductor devices.

## Claims

1. A process for fabricating a heterojunction transistor comprising the steps of:

forming a base region (15) having one conductivity type in a part of a single crystal silicon substrate (1) having the opposite conductivity type to generate a p-n junction the end portions of which are exposed on one main surface (11) of said silicon substrate;

covering said one main surface (11) of said single crystal silicon substrate (1) with an O-doped polycrystalline or amorphous silicon layer (7);

doping an impurity of said opposite conductivity type into a portion (71) of said O-doped polycrystalline or amorphous silicon layer (7) which is located on said base region (15) to generate an emitter region having said opposite conductivity type and forming a heterojunction with said base region (15); and

leaving a portion (72) of said O-doped polycrystalline or amorphous silicon layer (7) not doped with said impurity of opposite conductivity type as a passivation film.

2. The process as defined in claim 1 which further includes the step of doping an impurity having said one conductivity type to a portion (73) of said O-doped polycrystalline or amorphous silicon layer (7) which is positioned above the base region (15) in order to form base electrode contact region exhibiting the same conductivity type as that of the base region (15).

3. A heterojunction transistor comprising:

a) a single crystal silicon semiconductor substrate (1) including

i) a first semiconductor layer (15) of a first conductivity type, and

ii) a second semiconductor layer (13) of a second conductivity type opposite to the first conductivity type, the first and second semiconductor layers forming a p-n junction therebetween,

iii) the end portions of the p-n junction formed between the first semiconductor layer (15) and the second semiconductor layer (13) being exposed at one main surface (11) of the silicon substrate, and

iv) the first semiconductor layer (15) being surrounded by the second semiconductor layer;

b) an O-doped polycrystalline or amorphous silicon layer (7) extending on said one main surface, said O-doped polycrystalline or amorphous silicon layer being a single continuous layer and comprising

i) a first portion (71) which contacts the surface of a part of said first semiconductor layer (15),

ii) a second portion (72) which contacts the surface of a part of said first semiconductor layer and the surface of said second semiconductor layer (13), the second portion having a passivation function,

iii) the first portion (71) being doped with an impurity which provides said second conductivity type so as to form a heterojunction between the first semiconductor layer (15) and said first portion,

iv) the second portion (72) covering the end portions of said p-n junction,

v) a third portion (73) of the first conductivity type making contact with the remaining part of the first semiconductor layer (15);

c) a pair of main electrodes comprising

i) an emitter electrode (3) which comes into ohmic contact with the surface of said first portion (71), and

ii) a collector electrode (5) which comes into ohmic contact with the other main surface (12) of said silicon substrate (1), which other main surface is the surface of the silicon substrate opposite said one main surface (11); and

d) a base electrode (4) which is in electrical contact with said first semiconductor layer (15) through said third portion (73).

## Patentansprüche

1. Verfahren zur Herstellung eines Transistors mit Heteroübergang, das die Schritte umfaßt:

Bilden eines Basisbereichs (15) mit einem Leitfähigkeitstyp in einem Teil eines Einkristallsiliziumsubstrats (1) mit dem entgegengesetzten Leitfähigkeitstyp zur Erzeugung eines p-n-übergangs, dessen Endteile an einer Hauptoberfläche (11) des Siliziumsubstrats freiliegen;

Bedecken dieser einen Hauptoberfläche (11) des Einkristallsiliziumsubstrats (1) mit einer O-dotierten polykristallinen oder amorphen Siliziumschicht (7);

Dotieren einer Verunreinigung des entgegengesetzten Leitfähigkeitstyps in einen Teil (71) der O-dotierten polykristallinen oder amorphen Siliziumschicht (7), der sich auf dem Basisbereich (15) befindet, um einen Emitterbereich zu erzeugen, der den entgegengesetzten Leitfähigkeitstyp hat und einen Heteroübergang mit dem Basisbereich (15) bildet; und

Belassen eines Teils (72) der O-dotierten polykristallinen oder amorphen Siliziumschicht (7), der nicht mit der Verunreinigung des entgegengesetzten Leitfähigkeitstyps dotiert ist, als eine Passivierungsschicht.

2. Verfahren nach Anspruch 1, das weiter den Schritt des Dotierens einer Verunreinigung mit dem einen Leitfähigkeitstyp in einen Teil (73) der O-dotierten polykristallinen oder amorphen Siliziumschicht (7) umfaßt, der über dem Basisbereich (15) liegt, um einen Basiselektrodenkontaktbereich zu bilden, der den gleichen Leitfähigkeitstyp wie den des Basisbereichs (15) zeigt.

3. Transistor mit Heteroübergang, der aufweist:

a) ein Einkristall-Siliziumhalbleitersubstrat (1) mit

i) einer ersten Halbleiterschicht (15) eines ersten Leitfähigkeitstyps und

ii) einer zweiten Halbleiterschicht (13) eines zweiten, dem ersten Leitfähigkeitstyp entgegengesetzten Leitfähigkeitstyps, wobei die erste und zweite Halbleiterschicht einen p-n-Übergang dazwischen bilden,

iii) wobei die Endteile des zwischen der ersten Halbleiterschicht (15) und der zweiten Halbleiterschicht (13) gebildeten p-n-Übergangs an einer Hauptoberfläche (11) des Siliziumsubstrats freiliegen und

iv) die erste Halbleiterschicht (15) von der zweiten Halbleiterschicht umgeben ist,

b) eine O-dotierte polykristalline oder amorphe Siliziumschicht (7), die sich auf der einen Hauptoberfläche erstreckt, eine einzelne zusammenhängende Schicht ist und aufweist

i) einen ersten Teil (71) der im Kontakt mit der Oberflächen eines Teils der ersten Halbleiterschicht (15) ist,

ii) einen zweiten Teil (72), der im Kontakt mit der Oberfläche eines Teils der ersten Halbleiterschicht und der Oberfläche der zweiten Halbleiterschicht (13) ist, wobei der zweite Teil eine Passivierungsfunktion hat,

iii) wobei der erste Teil (71) mit einer Verunreinigung dotiert ist, die den zweiten Leitfähigkeitstyp liefert, so daß ein Heteroübergang zwischen der ersten Halbleiterschicht (15) und dem ersten Teil gebildet wird,

iv) der zweite Teil (72) die Endteile des p-n-Übergangs bedeckt,

v) einen dritten Teil (73) des ersten Leitfähigkeitstyps, der im Kontakt mit dem restlichen Teil der ersten Halbleiterschicht (15) ist;

c) ein Paar von Hauptelektroden mit

i) einer Emitterelektrode (3), die in ohmschen Kontakt mit der Oberfläche des ersten Teils (71) kommt, und

ii) einer Kollektorelektrode (5), die in ohmschen Kontakt mit der anderen Hauptoberfläche (12) des Siliziumsubtrats (1) kommt, welche andere Hauptoberfläche die der einen Hauptoberfläche (11) gegenüberliegende Oberfläche des Siliziumsubstrats ist; und

d) eine Basiselektrode (4), die im elektrischen Kontakt mit der ersten Halbleiterschicht (15) durch den dritten Teil (73) ist.

**Revendications**

1. Procédé pour fabriquer un transistor à hétérojonction, incluant les étapes consistant à:

former une région de base (15) possédant un premier type de conductivité dans une partie d'un substrat en silicium monocristallin (1), possédant le type de conductivité opposé, de manière à produire une jonction p-n, dont les parties d'extrémité sont à nu sur la surface principale (11) dudit substrat en silicium;

recouvrir ladite surface principale (11) dudit substrat en silicium monocristallin (1) avec une couche (7) de silicium polycristallin ou amorphe dopé par l'oxygène;

introduire une impureté de dopage possédant ledit type de conductivité opposé dans une partie (71) de ladite couche (7) de silicium polycristallin ou amorphe dopé par de l'oxygène, qui est située sur ladite région de base (15) de manière à produire une région d'émetteur possédant ledit type de conductivité opposé et formant une hétérojonction avec ladite région de base (15); et

laisser subsister une partie (72) de ladite couche (7) de silicium polycristallin ou amorphe dopé par de l'oxygène, non dopée par ladite impureté possédant le type de conductivité opposé, en tant que pellicule de passivation.

2. Procédé selon la revendication 1, qui inclut en outre l'étape consistant à introduire une impureté de dopage possédant ledit premier type de conductivité dans une partie (73) de ladite couche (7) de silicium polycristallin ou amorphe dopé par de l'oxygène, qui est située au-dessus de la région de base (15), de manière à former une région de contact avec l'électrode de base, qui présente le même type de conductivité que celui de la région de base (15).

3. Transistor à hétérojonction comprenant:

a) un substrat semiconducteur en silicium monocristallin (1) incluant

i) une première couche semiconductrice (15) possédant un premier type de conductivité, et

ii) une seconde couche semiconductrice (13) possédant un second type de conductivité, opposé au premier type de conductivité, les première et seconde couches semiconductrices formant entre elles une jonction p-n,

iii) les parties d'extrémité de la jonction p-n formées entre la première couche semiconductrice (15) et la seconde couche semiconductrice (13) étant à nu au niveau d'une surface principale (11) su substrat en silicium, et

iv) la première couche semiconductrice (15) étant entourée par la seconde couche semiconductrice;

b) une couche (7) en silicium polycristallin ou amorphe dopé par de l'oxygène, qui s'étend sur ladite surface principale, ladite couche de silicium polycristallin ou amorphe dopée par de l'oxygène étant constituée par une seule couche continue et comprenant:

i) une première partie (71), qui est en contact avec la surface d'une partie de ladite première couche semiconductrice (15),

ii) une seconde partie (72), qui est en contact avec la surface d'une partie de ladite partie de ladite première couche semiconductrice et avec la surface de ladite seconde couche semiconductrice (13), la seconde partie ayant une fonction de passivation,

iii) la première partie (71) étant dopée par une impureté fournissant ledit second type de conductivité de manière à former une hétérojonction entre la première couche semiconductrice (15) et ladite première partie,

iv) la seconde partie (72) recouvrant les parties d'extrémité de ladite jonction p-n,

v) une troisième partie (73) possédant le premier type de conductivité établissant un contact avec la partie restante de la première couche semiconductrice (15);

c) un couple d'électrodes principales comprenant

i) une première électrode d'émetteur (3), qui établit un contact ohmique avec la surface de ladite première partie (71), et

ii) une électrode de collecteur (5), qui établit un contact avec l'autre surface principale (12) dudit substrat en silicium (1), cette autre surface principale étant la surface du substrat en silicium située à l'opposé de ladite surface principale (11); et

d) une électrode de base (4), qui est en contact électrique avec ladite première couche semiconductrice (15) par l'intermédiaire de ladite troisième partie (73).

## FIG. 1

## FIG. 2

FIG. 3(a)

FIG. 3(b)

FIG. 3(c)

FIG. 3(d)

FIG. 3(e)

FIG. 4(a)

FIG. 4(b)

FIG. 4(c)